# EUROPEAN PATENT SPECIFICATION

(11) **EP 4 386 785 B1**
(45) Date of publication and mention of the grant of the patent: **11.12.2024**
(21) Application number: 22213266.4
(22) Date of filing: 13.12.2022
(51) Int. Cl.: H01F 27/28, G06N 3/044, G06N 3/0464, G06N 3/0895, G06N 3/09, G06N 3/094, G06N 5/01, G06N 20/20, G01R 31/72

(54) **METHOD AND SYSTEM OF MONITORING A WINDING PROCESS, METHOD OF MANUFACTURING A TRANSFORMER WINDING, AND METHOD AND SYSTEM FOR MANUFACTURING A TRANSFORMER**
VERFAHREN UND SYSTEM ZUR ÜBERWACHUNG EINES WICKLUNGSPROZESSES, VERFAHREN ZUR HERSTELLUNG EINER TRANSFORMATORWICKLUNG UND VERFAHREN UND SYSTEM ZUR HERSTELLUNG EINES TRANSFORMATORS
PROCÉDÉ ET SYSTÈME DE SURVEILLANCE D'UN PROCESSUS D'ENROULEMENT, PROCÉDÉ DE FABRICATION D'UN ENROULEMENT DE TRANSFORMATEUR, ET PROCÉDÉ ET SYSTÈME DE FABRICATION D'UN TRANSFORMATEUR

(43) Date of publication of application: 19.06.2024
(73) Proprietor: Hitachi Energy Ltd, 8050 Zürich (CH)
(72) Inventor: Sadr-Momtazi, Nima, 722 40 Västerås (SE); Eklund, Roger, 771 43 Ludvika (SE); Axelsson, Robin, 412 71 Göteborg (SE)
(74) Representative: Meier, Florian

(56) References cited:
- FARNSWORTH MICHAEL ET AL: "Augmented classification for electrical coil winding defects", THE INTERNATIONAL JOURNAL OF ADVANCED MANUFACTURING TECHNOLOGY, SPRINGER, LONDON, vol. 119, no. 11-12, 23 January 2022 (2022-01-23), pages 6949 - 6965, XP037778501, ISSN: 0268-3768, [retrieved on 20220123], DOI: 10.1007/S00170-022-08671-W
- YANG GUIHUA ET AL: "Research on Copper Foil Winding of Transformer Surface Defect Detection Based on Machine Vision", 2021 6TH INTERNATIONAL CONFERENCE ON INTELLIGENT INFORMATION PROCESSING, 29 July 2021 (2021-07-29) - 31 July 2021 (2021-07-31), New York, NY, USA, pages 187 - 192, XP093047678, ISBN: 978-1-4503-9063-7, [retrieved on 20230517], DOI: 10.1145/3480571.3480605
- HONG KAIXING ET AL: "Transformer Winding Fault Diagnosis Using Vibration Image and Deep Learning", IEEE TRANSACTIONS ON POWER DELIVERY, IEEE SERVICE CENTER, NEW YORK, NY, US, vol. 36, no. 2, 22 April 2020 (2020-04-22), pages 676 - 685, XP011845198, ISSN: 0885-8977, [retrieved on 20210323], DOI: 10.1109/TPWRD.2020.2988820

## Description

### TECHNICAL FIELD

Embodiments of the invention relate to the manufacture of a winding of an electric power system component. Embodiments of the invention relate in particular to a quality control method and system operative to detect mistakes in a winding process performed on a winding apparatus. Embodiments of the invention also relate to manufacturing systems and methods which comprise the quality control method or system according to embodiments.

### BACKGROUND

Transformers are important components of electric power systems. Transformers can have various configurations, depending on their intended use. The manufacture of transformers designed for use in electric power generation, transmission, and/or distribution is a very complex task, due to the specific requirements imposed on such transformers. This applies in particular to the manufacture of a transformer winding.

The design of transformer windings is optimized in view of its performance for a given amount of copper used . The design of transformer windings is also optimized to take up a small amount of space while still maintaining high reliability and efficient cooling and insulation. This makes the manufacturing process complex.

Errors during the winding process of forming a transformer winding are fortunately rare, but any failure has the potential of having severe negative effects on power supply, operation safety, and workforce safety.

Similar challenges exist in the winding process of forming windings of other electric power system components such as reactors.

Thus, quality control for a transformer winding or for windings of other electric power system components is an important issue to reduce the risk of a failure which can have catastrophic consequences.

Unfortunately, such a quality control is not easy to perform using conventional techniques. Mistakes are difficult to detect in view of the complexity of the winding process. Many mistakes, such as mistakes relating to the position of crossovers or erroneous deviations from design data, are hidden from view in the transformer winding. The challenges in error detection are particularly pronounced when a winding apparatus provides both a rotary and a translatory degree of freedom, causing the transformer winding to be both rotated around an axis and displaced in a translatory manner during manufacture.

FARNSWORTH MICHAEL ET AL: "Augmented classification for electrical coil winding defects", THE INTERNATIONAL JOURNAL OF ADVANCED MANUFACTURING TECHNOLOGY, SPRINGER, LONDON, vol. 119, no. 11-12, 23 January 2022 (2022-01-23), pages 6949-6965, ISSN: 0268-3768, DOI: 10.1007/S00170-022-08671-W discloses a machine vision technique for classification of electrical coil winding defects, which uses a ResNet-50 and Generative Adversarial Network (GAN) technique.

In view of the above, there is a need for methods and systems which mitigate the risk that a winding of an electric power system component that is not formed in accordance with its specification is used in a transformer or a transformer core or another electric power system component. There is in particular a need for methods and systems which allow quality issues to be detected while the winding process of forming the winding is in progress.

### SUMMARY

According to aspects of the invention, a method and a system as recited in the independent claims are provided. The dependent claims define preferred embodiments.

According to an aspect of the invention, there is provided a method of monitoring a winding process of forming a winding of an electric power system component (such as a transformer winding) on a winding apparatus. The method comprises processing, by a computer vision system, at least one image showing at least part of the winding (e.g., the transformer winding) captured during the winding process, wherein processing the at least one image comprises performing an object classification. The method further comprises detecting, by the computer vision system, a discrepancy between a result of the object classification and design data for the winding (e.g., the transformer winding).

The method of monitoring a winding process allows mistakes to be detected while the winding (e.g., the transformer winding) is still being formed. Thereby, mitigating and/or correcting actions may be taken during manufacture of the transformer winding.

The method of monitoring a winding process utilizes a computer vision system in combination with design data to detect a discrepancy therebetween. The discrepancy is an indicator that an error has occurred or may have occurred. Thus, the computer vision system provides assistance during the winding process of forming a transformer winding.

The method may comprise effecting, by the computer vision system, at least one action responsive to the detected discrepancy.

Thereby, one or several actions may be performed automatically or semi-automatically when there is a discrepancy detected by the computer vision system.

The at least one action may comprise causing, by the computer vision system, a human machine interface (HMI) to output information that depends on the detected discrepancy.

Thereby, the detected discrepancy may be used as trigger for an output action that can alert in operator of the winding apparatus that there has been or might have been a mistake in the winding process.

The information may comprise one, several, or all of: an alarm and/or warning; information indicating a location of the detected discrepancy; information indicating a time at which the detected discrepancy occurred; information on a root cause of the detected discrepancy; instructions for correcting the detected discrepancy.

Thereby, the detected discrepancy may be used as trigger for an output action that can alert in operator of the winding apparatus and that can optionally provide additional information that assists the operator in identifying the root cause of the mistake or that assists the operator in taking suitable or corrective a mitigating actions to correct the mistake in the winding process.

The at least one action may comprise a mitigating action and/or a corrective action.

Thereby, the detected discrepancy may be used as trigger for an action that may be performed automatically or semiautomatically to mitigate and/or correct the mistake that has been identified by the computer vision system.

The action may comprise stopping a rotation and/or translatory displacement of the winding apparatus.

Thereby, visual inspection or corrections to the winding process may be facilitated.

The winding apparatus may comprise a winding support on which the winding (e.g., the transformer winding) is formed. The winding apparatus may comprise one or several motors that drive the winding support. The winding apparatus may comprise a first motor that rotates the winding support and a second motor that causes a translatory displacement of the winding support, preferably along a rotation axis of the winding support.

Thereby, manufacture of the winding (e.g., the transformer winding) is facilitated. Additionally, such a configuration of the winding apparatus lends itself to a monitoring method using a computer vision system. An image acquisition device, such as a camera, can be mounted stationary, as the winding apparatus displaces the transformer winding as it is being formed so as to keep a top thereof at approximately a same height.

The method further comprises determining at least one image acquisition time of the at least one image during the winding process.

Thereby, the computer vision system can determine at which image acquisition times during the winding process the at least one image provides particularly good information for facilitating detection of mistakes. For illustration, the one or several image acquisition times may depend on how shields overlaid on conductors and/or fillers of the winding (e.g., the transformer winding) are positioned relative to the image acquisition device.

The method may further comprise performing an image acquisition device control and/or an image selection based on the determined at least one image acquisition time.

Thereby, image acquisition may be controlled in such a manner that the at least one image provides particularly good information for facilitating detection of mistakes. Alternatively or additionally, images that are particularly suitable for detection of mistakes that occurred during the winding process (e.g., because shields overlaid on conductors or fillers are positioned suitably relative to the image acquisition device) can be selected from a stream of images provided by the image acquisition device.

The at least one image acquisition time is determined based on at least one position of the winding apparatus. The at least one image acquisition time is determined based on a rotatory position and a translatory position of the winding apparatus. The design data are used in combination with the positions of the winding apparatus to determine the at least one image acquisition time. For illustration, the design data may be used to determine at which rotary and/or translatory positions of the winding apparatus shields, conductors, fillers, and/or crossovers and/or other winding components or structural features are suitably positioned in a field of view of the image acquisition device.

The at least one image acquisition time may be determined based on a stream of images acquired by the at least one image acquisition device. The computer vision system may use image processing techniques, such as edge detection techniques, Fourier-based techniques, and/or contrast-enhancing techniques, to identify the images in the stream that are most likely to provide information on whether mistake was made in the winding process.

The computer vision system may use a first machine learning (ML) model for determining the at least one image acquisition time. The first ML model may have a first input layer that receives pixels of images of the stream. The first ML model may have a first output layer that outputs a value indicating whether or not further analysis is to be performed on any of the images. Alternatively or additionally, the first input layer may receive winding apparatus positions, such as a rotatory and/or translatory position of a winding support on which the transformer winding is being formed.

Processing the at least one image may comprise identifying a region of interest (ROI) in which the object classification is to be performed.

Thereby, object classification can be focused on a region in which a discrepancy, if any, is likely to be visible.

Boundaries of the ROI may comprise edges of shields of the transformer winding.

Thereby, object classification can be focused on a region between adjacent shields that are interposed between successive discs of a transformer winding.

Alternatively or additionally, boundaries of the ROI may comprise inner and outer circumferential edges of a layer formed by conductors and fillers.

Thereby, object classification can be focused on a region in which winding errors are prone to being encountered.

Identifying the ROI may comprise performing an edge detection.

Thereby, the ROI may be identified efficiently.

Identifying the ROI may comprise applying at least one ROI classifier to the at least one image. Several ROI classifiers may be applied to the at least one image. Each of the one or more ROI classifiers may indicate, for each pixel, whether the respective pixel is classified as being within the ROI or outside the ROI.

The one or several ROI classifiers may comprise at least one second ML model. The at least one second ML model may have a second input layer that receives pixels of the at least one image. The at least one second ML model may have a second output layer that outputs, for every pixel, a value indicating whether or not the respective pixel is in the ROI.

The at least one second ML model may comprise a deep learning ML model.

Thereby, the object classification task can be performed reliably.

The at least one a second ML model may comprise a U-Net ML model.

Thereby, the ROI identification task can be performed reliably.

The object classification may comprise performing at least one third ML model. The at least one third ML model may have a third input layer that receives pixels located within the ROI. The at least one third ML model may have a third output layer that outputs object classifiers indicating to which one of several object classes the respective pixel in the ROI is assigned. The third output layer may indicate a probability that an object belongs to a given object class (such as filler, conductor, shield, and/or crossover).

The third ML model may comprise a random forest (RF) model, without being limited thereto.

Thereby, the object classification task can be performed in a manner that provides particularly good results during inference.

The object classification may classify at least conductors, fillers, and shields in the at least one image.

Alternatively, or additionally, the object classification may classify crossovers. The object classification may classify inner and outer crossovers.

Alternatively, or additionally, the object classification may classify other components and/or other structural features of the transformer winding.

Thereby, object classes are implemented which lend themselves for a comparison with design data.

Several classifiers may be used, each associated with and trained for recognizing a given object class (such as filler, conductor, shield, and/or crossover).

The object classification may define a sequence of objects that comprises at least conductors and fillers as arranged in a radial direction (e.g. from inside for outside or from outside to inside), as identified in the ROI of the image.

Processing the at least one image may comprise using one or several position measurements of the winding apparatus. The one or several position measurements may comprise a rotatory and/or translatory position measurement. The one or several position measurements may be received from sensors. Alternatively, the one or several position measurements may be received from a controller of the winding apparatus.

The one or several position measurements may be used for determining which images are to be analyzed further, e.g., by performing ROI determination and object classification. Alternatively or additionally, the one or several position measurements may be used in assisting the ROI determination.

Processing the at least one image may comprise executing at least one ML model having an input layer that receives at least part of the at least one image and/or winding apparatus positions, wherein the at least one ML model has an output layer, wherein the output layer provides at least one of: at least one image acquisition time defining the at least one image that is to be processed; an ROI in which the object classification is to be performed; and/or object classifiers indicating to which one of several predetermined object classes objects respectively are assigned.

The method may further comprise determining, based on the design data, a target sequence of objects in a radial direction of the transformer winding.

Thereby, the design data are converted into a format that can be readily compared to the results of the object classification.

The design data may comprise at least one crossover diagram.

The design data may define the winding as a three-dimensional volumetric component. The design data may have various formats, such as one or several crossover diagrams, without being limited thereto.

Determining the target sequence of objects may comprise generating, based on the at least one crossover diagram, a machine readable representation indicating the target sequence. The machine readable representation may comprise an XML representation, without being limited thereto.

Detecting the discrepancy may comprise comparing the target sequence and the result of the object classification.

The target sequence may be determined automatically by the computer vision system, or a processing system communicatively coupled thereto.

The winding (e.g., the transformer winding) may comprise several layers (also referred to as discs in the art). The at least one image may show at least one of the several layers at an upper face of the winding as it is being formed on the winding apparatus. The image of the uppermost layer at the upper face of the winding may be processed in the method to detect the discrepancy.

Processing at least one image and comparing the result of the object classification to the design data may be repeated in an ongoing basis (i.e. continually) during the winding process.

When the method uses one or several ML models (such as one, several, or all of the first, second, and third ML models mentioned above), the ML model may be trained using labeled image data. The labeled image data may comprise synthetically generated images which are generated from real-world images that show an error during the winding process. Generation of the synthetically generated images may comprise one or several image modification operations, such as rotations, translations, mirroring, adding distortions, etc.

The one or several ML models may be trained using supervised training or semi--supervised training.

The method may further comprise training the ML model using labeled image data.

The training may be performed by a computer system distinct and separate from the computer vision system or may be performed by the computer vision system.

Training the ML model may comprise synthetically generating images from real-world images that show an error during the winding process. Generation of the synthetically generated images may comprise one or several image modification operations, such as rotations, translations, mirroring, adding distortions, etc.

The synthetically generated images allow a more balanced training set to be provided, improving the results when the ML model is subsequently employed for inference during field use of the computer vision system.

The ML model may be trained to perform at least one the classification task. The at least one classification task may be or may comprise one or several of: classifying an image is being an image that is to be processed; classifying pixels as belonging to an ROI; performing an object classification.

The ML model may comprise at least one of: a deep learning model, such as a U-Net model; a random forest model; a recurrent neural network (RNN); a convolutional neural network (CNN).

Synthetically generating images may comprise generating the synthetic images using an adversarial ML model.

The transformer winding may be a transformer winding of a power generation and transmission system, such as a high-voltage a medium voltage power transmission system, of a power distribution system, of a railway transformer, or of a reactive or inductive system, or a shunt reactor, such as a variable reactor or other shunt reactor.

There is also disclosed a method of training at least one ML model for use in monitoring a winding process of forming a winding of an electric power system component (such as a transformer winding) on a winding apparatus.

The method may comprise training one or several ML models (such as one, several, or all of the first, second, and third ML models mentioned above), using labeled image data showing windings (such as transformer windings) as they are being formed.

The training method may comprise synthetically generating at least some training images from real-world images that show an error during the winding process. Generating the synthetically generated images may comprise one or several image modification operations, such as rotations, translations, mirroring, adding distortions, etc.

The one or several ML models may be trained using supervised training or semi--supervised training.

The training may be performed by a computer system distinct and separate from the computer vision system or may be performed by the computer vision system.

The synthetically generated images allow a more balanced training set to be provided, improving the results when the ML model is subsequently employed for inference during field use of the computer vision system.

The training method may comprise training the at least one ML model to perform at least one classification task. The at least one classification task may be or may comprise one or several of: classifying an image is being an image that is to be processed; classifying pixels as belonging to an ROI; performing an object classification.

The at least one ML model may comprise at least one of: a deep learning model, such as an Unet model; a random forest model; a recurrent neural network (RNN); a convolutional neural network (CNN).

Synthetically generating images may comprise generating the synthetic images using an adversarial ML model.

The training method may be performed by a computer vision system that executes the trained ML model(s) during inference or by a computing system separate from the computer vision system.

The training method may comprise deploying the trained ML model(s) to a computer vision system for monitoring a winding process of forming a transformer winding on a winding apparatus.

According to another aspect of the invention, there is provided a method of manufacturing a winding of an electric power system components (such as a transformer winding). The method comprises controlling, by at least one control device, a winding apparatus on which the winding (e.g., the transformer winding) is formed. The method comprises performing the method of monitoring a winding process according to any one of the embodiments while the transformer winding is being formed.

The method may further comprise correcting at least one mistake made during the winding process responsive to the detected discrepancy.

The method may further comprise discarding the transformer winding responsive to the detected discrepancy.

The method may be performed automatically by a system which comprises a winding apparatus and a computer vision system operative to perform the monitoring method discussed in detail herein. The computer vision system may be operated if he coupled to a controller of the winding apparatus.

According to another aspect of the invention, there is provided a method of manufacturing a transformer core. The method comprises assembling the transformer core comprising the at least one transformer winding manufactured using the method of manufacturing a transformer winding according to an embodiment.

Assembling the transformer core may comprise assembling the at least one transformer winding with a yoke.

The yoke may comprise a laminate comprising several layers. This allows the magnetic flux to be transferred efficiently in the transformer core.

The transformer core may be a transformer core of a power transmission system, such as a high-voltage a medium voltage power transmission system, of a power distribution system, of a railway transformer, or of a reactive or inductive system.

According to another aspect of the invention, there is provided a method of manufacturing a transformer. The method comprises assembling the transformer comprising the at least one transformer winding manufactured using the method of manufacturing a transformer winding according to an embodiment.

Assembling the transformer may comprise assembling the at least one transformer winding with a yoke.

The yoke may comprise a laminate comprising several layers. This allows the magnetic flux to be transferred efficiently in the transformer core.

Assembling the transformer may comprise arranging the at least one transformer winding in a transformer tank.

Assembling the transformer may comprise filling an interior of the transformer tank with an insulating fluid, such as an insulation oil.

The transformer may be a transformer of a power transmission system, such as a high-voltage a medium voltage power transmission system, of a power distribution system, or of a railway system, or a reactor, such as a variable reactor or shunt Reactor.

According to another aspect of the invention, there is provided a system configured to monitor a winding process of forming a winding of an electric power system component (such as a transformer winding). The system comprises a computer vision system configured to process at least one image showing at least part of a winding (e.g., a transformer winding) captured during the winding process to perform an object classification, detect a discrepancy between results of the object classification and design data for the winding, and perform an action responsive to the detected discrepancy.

The system for monitoring a winding process allows mistakes to be detected by the winding of the electric power system component is still being formed. This enables mitigating and/or correcting actions to be taken during manufacture of the transformer winding.

The system for monitoring a winding process utilizes a computer vision system in combination with design data to detect a discrepancy therebetween. The discrepancy is an indicator that an error has occurred or may have occurred. Thus, the computer vision system provides assistance during the winding process of forming the winding of the electric power system component (e.g., the transformer winding).

The system may further comprise a human machine interface (HMI). The computer vision system is configured to control the HMI responsive to the detected discrepancy.

The system may be configured such that the information may comprise one, several, or all of: an alarm and/or warning; information indicating a location of the detected discrepancy; information indicating a time at which the detected discrepancy occurred; information on a root cause of the detected discrepancy; instructions for correcting the detected discrepancy.

The system may be configured such that the at least one action may comprise a mitigating action and/or a corrective action. The system may be configured to generate and output a control signal or control command for the winding apparatus or an HMI.

The system may be configured such that the action may comprise stopping a rotation and/or translatory displacement of the winding apparatus.

The system may further comprise the winding apparatus. The winding apparatus may comprise a winding support on which the winding (e.g., the transformer winding) is formed. The winding apparatus may comprise one or several motors that drive the winding support. The winding apparatus may comprise a first motor that rotates the winding support and a second motor that causes a translatory displacement of the winding support, preferably along a rotation axis of the winding support.

The system is configured to determine at least one image acquisition time of the at least one image during the winding process.

The system may be configured to perform an image acquisition device control and/or an image selection based on the determined at least one image acquisition time.

The system is configured such that the at least one image acquisition time is determined based on at least one position of the winding apparatus. The at least one image acquisition time is determined based on a rotatory and a translatory position of the winding apparatus. The design data are used in combination with the position(s) of the winding apparatus to determine the at least one image acquisition time. For illustration, the design data may be used to assess at which rotary and/or translatory positions of the winding apparatus shields, conductors, fillers, and/or crossovers and/or other components or structural features are suitably positioned in a field of view of the image acquisition device.

The system may be configured such that the at least one image acquisition time may be determined based on a stream of images acquired by the at least one image acquisition device. The computer vision system may use image processing techniques, such as edge detection techniques, Fourier-based techniques, and/or contrast-enhancing techniques, to identify the images in the stream that are most likely to provide information on whether a mistake was made in the winding process.

The system may be configured such that the computer vision system may use a first machine learning (ML) model for determining the at least one image acquisition time. The first ML model may have a first input layer that receives pixels of images of the stream. The first ML model may have a first output layer that outputs a value indicating whether or not further analysis is to be performed on any of the images and, if so, on which of the images. Alternatively or additionally, the first input layer may receive winding apparatus positions, such as a rotatory and/or translatory position of a winding support on which the transformer winding is being formed.

The system may be configured to identify a region of interest (ROI) in which the object classification is to be performed.

The system may be configured such that boundaries of the ROI may comprise edges of shields of the transformer winding.

Alternatively or additionally, the system may be configured such that boundaries of the ROI may comprise inner and outer circumferential edges of a layer formed by conductors and fillers.

The system may be configured to perform an edge detection to detect the ROI.

The system may be configured to apply at least one ROI classifier to the at least one image. Several ROI classifiers may be applied to the at least one image. Each of the one or more ROI classifiers may indicate, for each pixel, whether the respective pixel is classified as being within the ROI or outside the ROI.

The one or several ROI classifiers may comprise at least one second ML model. The at least one second ML model may have a second input layer that receives pixels of the at least one image. The at least one second ML model may have a second output layer that outputs, for every pixel, a value indicating whether or not the respective pixel is in the ROI.

The at least one second ML model may comprise a deep learning ML model.

The at least one a second ML model may comprise a U-Net ML model.

The system may be configured such that the object classification may comprise performing at least one third ML model. The at least one third ML model may have a third input layer that receives pixels located within the ROI. The at least one third ML model may have a third output layer that outputs object classifiers indicating to which one of several object classes the respective pixel in the ROI is assigned.

The third ML model may comprise a random forest (RF) model, without being limited thereto.

The system may be configured such that the object classification may classify at least conductors, fillers, and shields in the at least one image, and/or other components and/or structural features of the winding.

Alternatively or additionally, the system may be configured such that the object classification may classify crossovers. The object classification may classify inner and outer crossovers.

The object classification may define a sequence of objects that comprises at least conductors and fillers as arranged in a radial direction (e.g. from inside for outside or from outside to inside), as identified in the ROI of the image.

The system may be configured such that processing the at least one image may comprise using one or several position measurements of the winding apparatus. The one or several position measurements may comprise a rotatory and/or translatory position measurement. The one or several position measurements may be received from sensos. Alternatively, the one or several position measurements may be received from a controller of the winding apparatus.

The system may be configured to use the one or several position measurements for determining which images are to be analyzed further, e.g., by performing ROI determination and object classification. Alternatively or additionally, the system may be configured to use the one or several position measurements in assisting the ROI determination.

The system may be configured such that processing the at least one image may comprise executing at least one ML model having an input layer that receives at least part of the at least one image and/or winding apparatus positions, wherein the at least one ML model has an output layer, wherein the output layer provides at least one of: at least one image acquisition time defining the at least one image that is to be processed; an ROI in which the object classification is to be performed; and/or object classifiers defining one of several predetermined object classes.

The system may be configured to determine, based on the design data, a target sequence of objects in a radial direction of the transformer winding.

The design data may comprise at least one crossover diagram.

The design data may define the winding (e.g., transformer winding) as a three-dimensional volumetric component. The design data may have various formats, such as one or several crossover diagrams, without being limited thereto.

The system may be configured such that determining the target sequence of objects may comprise generating, based on the at least one crossover diagram, a machine readable representation indicating the target sequence. The machine readable representation may comprise an XML representation, without being limited thereto.

The system may be configured such that detecting the discrepancy may comprise comparing the target sequence and the result of the object classification.

The computer vision system may be configured to determine the target sequence. Alternatively, system may further comprise a processing system communicatively coupled to the computer vision system and configured to determine the target sequence and provide the target sequence to the computer vision system.

The system may be configured to monitor a winding process for a winding of an electric power system (such as a transformer winding) that comprises several layers (also referred to as discs in the art). The at least one image may show at least one of the several layers at an upper face of the transformer winding as it is being formed on the winding apparatus. The image of the uppermost layer at the upper face of the transformer winding may be processed in the method to detect the discrepancy.

The system may be configured to repeat processing at least one image and comparing the result of the object classification to the design data may be repeated in an ongoing basis (i.e. continually) during the winding process.

When the system is configured to use one or several ML models (such as one, several, or all of the first, second, and third ML models mentioned above), the ML model may be trained using labeled image data. The labeled image data may comprise synthetically generated images which are generated from real-world images that show an error during the winding process. Generation of the synthetically generated images may comprise one or several image modification operations, such as rotations, mirroring, adding distortions, etc.

The ML model may comprise at least one of: a deep learning model, such as a U-Net model; a random forest model; a recurrent neural network (RNN); a convolutional neural network (CNN).

The transformer winding may be a transformer winding of a power transmission system, such as a high-voltage a medium voltage power transmission system, of a power distribution system, of a railway transformer, or of a reactive or inductive system (such as a shunt reactor and/or a variable reactor).

According to another aspect of the invention, there is provided a manufacturing system for manufacturing a transformer winding. The system comprises a winding apparatus and the system configured to monitor a winding process of forming a transformer winding according to an embodiment.

There is also disclosed machine-readable instruction code which, when executed by at least one programmable circuit, causes the programmable circuit to perform the method according to an embodiment.

There is also disclosed a non-transitory storage medium having stored thereon machine-readable instruction code which, when executed by at least one programmable circuit, causes the programmable circuit to perform the method according to an embodiment.

There is also disclosed a transformer winding, transformer core, or transformer manufactured using the method according to an embodiment.

The effects attained by the systems according to embodiments correspond to the effects disclosed in detail in association with the methods according to embodiments.

Various effects and advantages are attained by embodiments of the invention. The systems and methods allow mistakes to be detected by a winding process is still ongoing. This allows corrective and/or a mitigating actions to be taken during the winding process. Even if the mistake is such that it cannot be repaired, the systems and methods provide advantages, as the winding process can be terminated early (i.e. prior to completion of the transformer winding), thereby reducing based of material.

The systems and methods also are capable of detecting mistakes that would be located in the interior of the transformer winding if the winding process were completed. This provides a considerable advantage over techniques that analyze the transformer winding after completion of the winding process.

The systems and methods are configured such that they can monitor the winding process automatically, using images acquired by one or several image acquisition devices such as cameras.

The systems are configured for use with the formation of components of transformers that have a complex configuration and structure, such as transformers of electric power transmission systems or power distribution systems.

### BRIEF DESCRIPTION OF THE DRAWINGS

Embodiments of the invention will be described with reference to the drawings in which similar or identical reference signs designate elements with similar or identical configuration and/or function.
Figure 1 shows a system comprising a monitoring system.
Figure 2 shows a monitoring system.
Figure 3 shows a flow chart.
Figure 4 shows a flow chart
Figure 5 shows a monitoring system.
Figure 6 shows an image illustrating ROI detection and object classification.
Figure 7 shows an image illustrating ROI detection.
Figure 8 shows a block diagram of a monitoring system.
Figure 9 shows a flow chart.
Figure 10 shows a flow chart.
Figure 11 shows a transformer.
Figure 12 shows an assembly system.
Figure 13 shows a flow chart.

### DETAILED DESCRIPTION OF EMBODIMENTS

Embodiments of the invention will be described with reference to the drawings. In the drawings, similar or identical reference signs designate elements with similar or identical configuration and/or function.

While embodiments will be described in association with transformer windings configured to be installed in transformers of an electric power transmission or distribution system, the embodiments are not limited thereto. While embodiments will be described in association with certain winding configurations, such as a transformer windings that comprises several discs in which spacers are arranged between the discs, the embodiments are not limited thereto.

The features of embodiments may be combined with each other unless specifically stated otherwise.

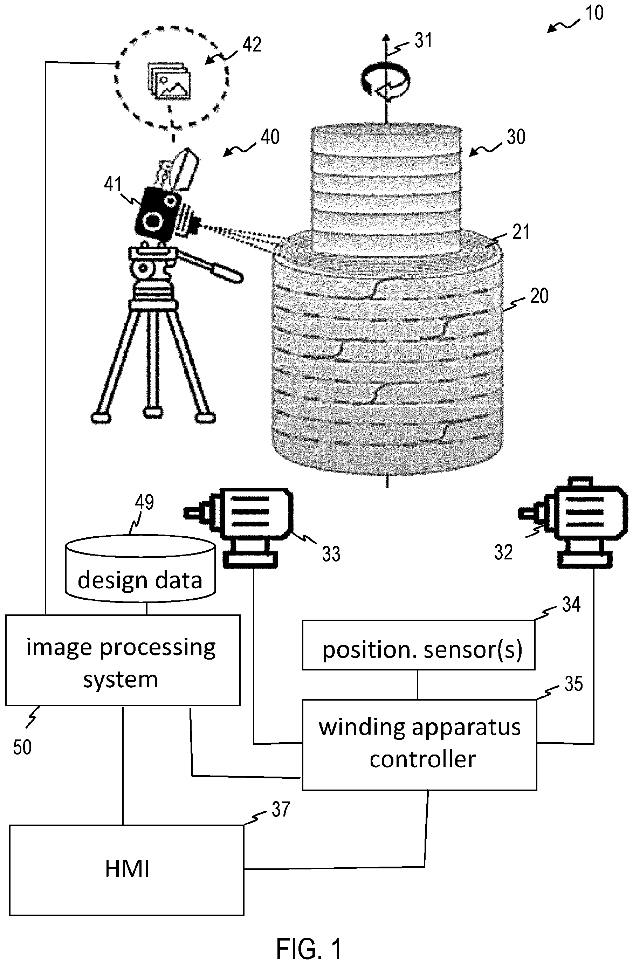

Figure 1 shows a system 10 according to an embodiment. The system 10 is configured to perform a winding process of forming a transformer winding. The system 10 is configured to monitor the winding process in which a transformer winding 20 is being formed. The system 10 comprises a computer vision system 40 that is used to monitor the winding process to detect mistakes that might have happened during the winding process.

The system 10 comprises a winding apparatus 30. The winding apparatus 30 comprises a winding support on which the transformer winding is being supported during its winding process. The winding apparatus 30 may be configured to rotate the transformer winding 20 around an axis 31 while the transformer winding is being formed. The winding apparatus 30 may be configured to shift the already formed portion of the transformer winding 20 along the axis 31 in a translatory manner. A shift along the axis 31 may be performed respectively after a layer (or disc) of the transformer winding 20 has been completed. A distance by which the already formed portion of the transformer winding 20 is shifted may correspond to a height of each disc formed during one full rotation of the winding apparatus, possibly including spacers that are interposed between adjacent layers.

The winding apparatus 30 may comprise a first motor 32 configured to rotate the transformer winding during the winding process.

The winding apparatus 30 may comprise a second motor 33 configured to displace the transformer winding 20 in a translatory manner during the winding process. Translatory displacement may be effected intermittently, e.g., in an incremental, step-wise manner. Translatory displacement may be effected upon completion of a full revolution about the axis 31. As will be described in more detail below, the translatory displacement along the axis 31 also provides the effect that images captured by an image acquisition device 41 for use in visual quality monitoring remains at approximately a same height above a topmost face 21 of the partially wound transformer coil 20 during the winding process.

The winding apparatus 30 may comprise one or several position sensors 34. The one or several position sensors 34 may be configured to measure a rotational and/or translatory position of the winding apparatus 30. The position measurements may be used by an image processing system 50 of the computer vision system 40 to determine, e.g., which images warrant further processing, and/or to perform ROI detection.

In addition or as an alternative to receiving position measurements from the position sensor(s) 34, the computer vision system may receive position information from a winding apparatus controller 35.

The computer vision system comprises an image processing system 50. The image processing system 50 will be described in more detail below.

The image processing system 50 generally is configured to process images 42 captured by one or several image acquisition devices 41. The one or several image acquisition devices 41 may be mounted in a stationary manner relative to a frame of the winding apparatus 30. Translatory displacement effected by the winding apparatus along the axis 31 prevents excessive variations in angle between an optical axis of the image acquisition device 40 one and the topmost layer 21 of the transformer winding 20 that is being wound.

The image processing system 50 is configured to at least perform an object classification. The object classification may specify a series of different objects such as conductors and fillers seen in a radial direction from a radially inner edge to a radially outer edge of the topmost layer 21 of the formed portion of the transformer winding 20.

The image processing system 50 may optionally be configured to perform additional processing of the images 42. For illustration, the image processing system 50 may be configured to perform a preprocessing which attains one or several of: adjusting for perspective effects; contrast enhancement; identification of periodic features; elimination of light reflections; etc.

Alternatively or additionally, the image processing system 50 may be configured to perform a region of interest (ROI) determination. The ROI determination may be implemented as a classifier. The classifier may provide a binary output indicating, for any pixel, whether the respective pixel is included in the ROI. Object classification may then be limited to the ROI. When the transformer winding 20 comprises several layers with shields arranged therebetween, the ROI classifier may be operative to distinguish pixels representing a conductor or filler from pixels representing a shield.

The image processing system 50 uses the results of the object classification and design data 49 specifying a target design of the transformer coil 20 to detect a discrepancy, which indicates a mistake that happened during the winding process. The image processing system 50 or a separate computing system coupled thereto may process the design data 49 into a format which can be compared to the object classification result. For illustration, design data 49 that comprises one or several crossover diagrams may be converted automatically into a list specifying, for a desired rotational and translatory position of the winding apparatus 30, which objects are expected to be present in any ROI within the field of view of the image acquisition device 41.

When the image processing system 50 detects the discrepancy between the results of the object classification and what is expected in accordance with the design data, we image processing system 50 may trigger an action. The action may comprise an output via a human machine interface (HMI) 37. The output may indicate that a discrepancy was detected, but may also include additional information, such as information indicating a location at which the discrepancy was detected and/or suggestions for how the identified discrepancy could be corrected, if such a correction is possible. Additionally alternatively, the output may affect operation of the winding apparatus 30. For illustration, the image processing system 50 may trigger the winding apparatus controller 35 to halt rotatory and/or translatory displacement in response to the detected discrepancy. This facilitates a visual inspection by a human operator and possible corrective actions.

Additional features of the image processing system according to embodiments will be described in more detail next.

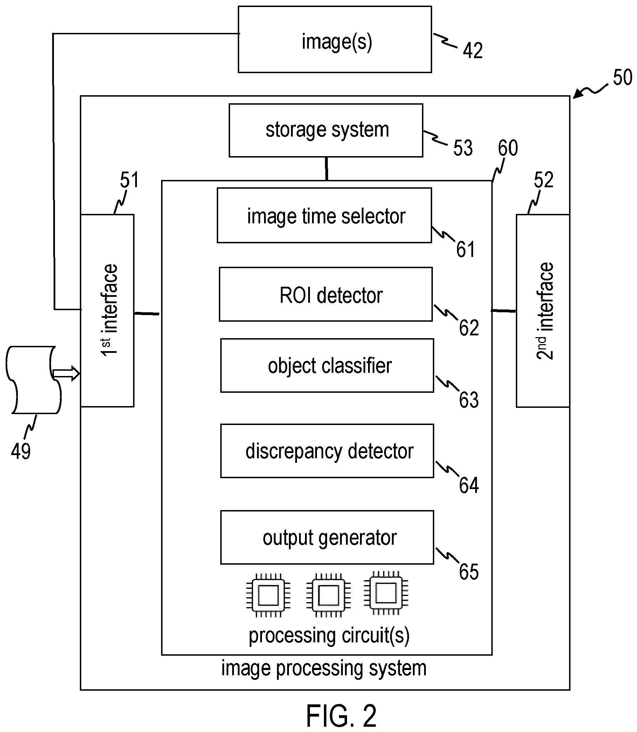

Figure 2 shows an image processing system 50. The image processing system 50 has at least one first interface 51 to receive images 42. The received images 42 show at least part of a top end face 21 of the transformer winding 20 during various stages of the winding process. The at least one first interface 51 may be a data interface configured to receive the images 42 as digital data. The at least one first interface 51 may also be configured to receive the design data 49 that specifies the desired target configuration of the transformer winding 20.

A result of the processing performed by the image processing system 50 may be output via the at least one first interface 51. Alternatively, the image processing system 50 may have at least one second interface 52 configured to be communicatively coupled to the winding apparatus controller 35 and/or the HMI 37. The image processing system 50 may generate and output a signal or command to trigger an action, such as providing information on the detected discrepancy by the HMI 37 and/or causing the winding apparatus controller 35 to react to the detected discrepancy.

The image processing system 50 may comprise a storage system 53. Images, such as a stream of images received from the image acquisition device(s) 41, may be temporarily stored in the storage system 53 for processing and further analysis. The storage system 53 may also include parameters used for processing the images 42, such as parameters of a ROI classifier that has been trained to identify a ROI in an image and/or parameters of an object classifier that has been trained to distinguish different objects such as conductors, fillers, shields and/or crossovers and/or other components or structural features of the winding.

The image processing system 50 may comprise one or several processing circuits 60. The one or several processing circuits 60 may be programmable circuits. The one or several processing circuits may comprise any one or any combination of integrated circuits, integrated semiconductor circuits, processors, controllers, application specific integrated circuits (ASICs), field programmable gate arrays (FPGAs), circuit(s) including quantum bits (qubits) and/or quantum gates, without being limited thereto.

The image processing system 50 may comprise an image time selector 61. The image time selector 61 may receive the winding apparatus position(s) and/or a stream of image included in the images 42 as input. The image time selector 61 may then determine which images are to be processed further to perform object classification. The image time selector 61 may select an already captured image from the stream of images for processing it in more detail. Alternatively or additionally, the image time selector 61 may predict at which image acquisition times images are to be taken in order to be particularly useful for detecting a potential discrepancy with the design data. The image processing system 50 may cause the image acquisition device(s) 41 to capture an image, in accordance with an output of the image time selector 61.

The image processing system 50 may comprise a ROI detector 62. The ROI detector 62 may comprise a first classifier, which is also referred to as ROI classifier herein. The ROI detector 62 receives pixels of an image, possibly of the preprocessing of the image. The ROI detector 62 may classify each pixel as being a pixel belonging to an ROI or being a pixel not belonging to any ROI. The ROI detector 62 may use edge detection techniques. Alternatively or additionally, the ROI detector 62 may comprise one or several trained ML models that are suitable for perform an image segmentation task. Deep learning models are one example of such ML models, but the implementation of the ROI detector 62 is not limited thereto.

The image processing system 50 may comprise an object classifier 63. The object classifier 63 is configured to classify each pixel in at least an ROI as belonging to one of several object classes, which represent different physical component types included in the transformer winding 20. For illustration, the object classes may comprise object classes for conductors (it being understood that the conductors may be covered with a dielectric material), for fillers that can be arranged between conductors within a layer (also referred to as a disc) of the transformer winding, or for shields that can be arranged between adjacent layers of the transformer winding. This list is not exhaustive. Additional or alternative object classes can be provided to reflect components and/or structural features of the winding.

More than one object classifiers 63 may be used. For illustration, the may be provided one object classifier that this specifically adapted to distinguish conductors, fillers, and shields, and another object classifier that this specifically adapted to identify a crossovers and/or to distinguish in a crossovers from order crossovers.

The image processing system 50 may comprise a discrepancy detector 64 configured to detect a discrepancy between the objects classified by the object classifier 63 and a sequence of objects expected, for example, in a radial direction of the transformer winding's topmost layer 21 in accordance with the design data 49.

The image processing system 50 may comprise an output generator 65. The output generator 65 may be configured to generate, responsive to an output of the discrepancy detector 64, a command or signal that triggers an action. The action may comprise the provision of information related to the detected discrepancy, such as a warning or alarm, and/or a mitigating or corrective action.

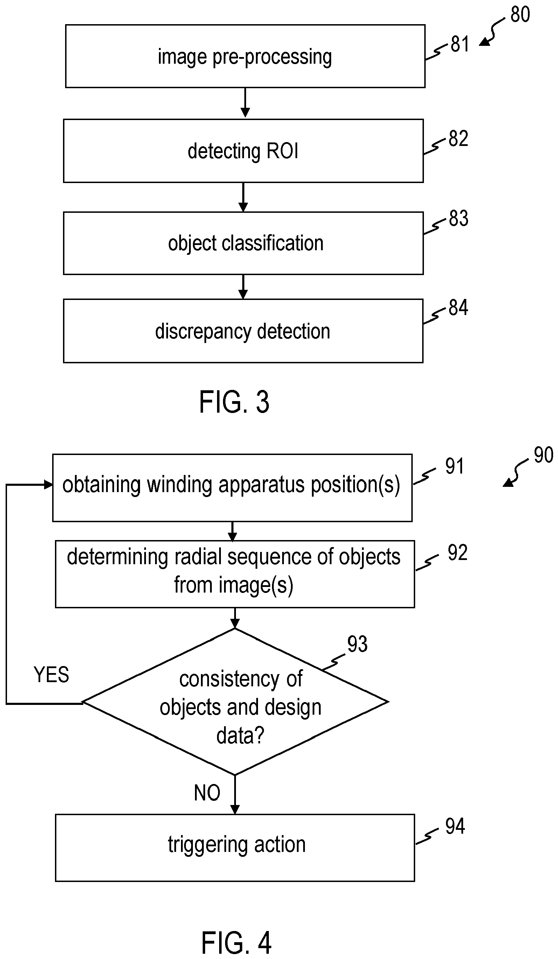

Figure 3 is a flow chart of a method 80. The method 80 may be performed automatically by the computer vision system 40 or the image processing system 50 of the computer vision system 40.

At process block 81, image preprocessing is performed. The image preprocessing may comprise correcting perspective effects (e.g., by applying a transformer matrix to the image), edge enhancement, contrast enhancement, etc. The image preprocessing may comprise performing at least one transformation of the image, which depends on intrinsic and/or extrinsic camera parameters of a camera of the image acquisition device. The intrinsic and/or extrinsic camera parameters may be known (e.g., provided by a manufacturer of the camera) or determined in a calibration routine.

At process block 82, an ROI is detected. Detecting the ROI may comprise at the edge detection. The ROI may be detected such that it is delimited by edges of shields on the topmost layer 21 end by radially inner and outer circumferences of the topmost layer 21.

At process block 83, object classification is performed. The object classification may discriminate different physical components present in the transformer winding 20. The object classification may determine in which a sequence conductors and filler are arranged in a radial direction of the transformer winding 20. The object classification may additionally or alternatively discriminate different structural features (such as crossovers) present in the transformer winding 20.

At process block 84, possible discrepancies between the results of the object classification and design data are detected. In response to detection of a discrepancy, an action may be performed.

Sensor signals may be used in various stages of the process. The sensor signals may be indicative of winding apparatus positions. The sensor signals may be indicative of a translatory and/or rotatory position of the winding apparatus.

The winding apparatus position may be used in various ways. For illustration, the sensor signals may determine which image preprocessing is to be applied to accommodate the respective height difference between the image acquisition device 41 and the topmost layer 21. The winding apparatus position may also be used when performing ROI detection.

The winding apparatus position may also be used when determining, based on the design data, which sequence of objects is expected to be present in the image (e.g., in the ROI) for the given winding apparatus position.

Figure 4 is a flow chart of a method 90. The method 90 may be performed automatically by the computer vision system 40 or the image processing system 50 of the computer vision system 40.

At process block 91, winding apparatus positions are obtained. The winding apparatus positions may be obtained from the sensor(s) 34 or the winding apparatus controller 35.

At process block 92, the sequence of objects, e.g. in the topmost layer 21, is determined from one or several images 42. The sequence of objects may be determined in a radial direction from an inner circumference to an outer circumferences of the topmost layer 21. The sequence of objects may be determined as previously described using, for example, ROI detection and object classification.

At process block 93, it is determined whether the determined sequence of objects and design data are consistent with each other. If there is consistency (as is usually the case), the process returns to process block 91. The various process blocks may be repeated for a plurality of rotatory and a plurality of translatory winding apparatus positions.

At process block 94, if there is an inconsistency between that detected sequence of objects in the design data, an action is triggered. As previously described, the action may comprise controlling an HMI and/or triggering a corrective and/or mitigating action.

The various classifiers that may be used in the computer vision system 40 and, more specifically, in the image processing system 50 may be implemented using the techniques such as: edge detection (for, e.g., detecting the ROI or detecting boundaries between different objects within the ROI), detecting periodicity (for, e.g., detecting a periodic arrangement of layers at an outer cylindrical surface of the transformer winding and/or for detecting a sequence of objects within the ROI),; but are not limited thereto.

One or several of the classifiers may be implemented using a trained ML model. More than one ML model may be used. For illustration, the image processing system 50 may comprise a first ML model configured to determine at which image acquisition times the most relevant images are captured that Walrond further analysis. Alternatively or additionally, the image processing system 50 may comprise a second ML model configured to detect the ROI. Alternatively or additionally, the image processing system 50 may comprise a third ML model configured to perform the object classification.

Several trained ML models or other classifiers may be deployed and used for performing any one of these functions. For illustration, several ROI classifiers may be applied to the same image data to attain an even more accurate detection of possible mistakes in the winding process.

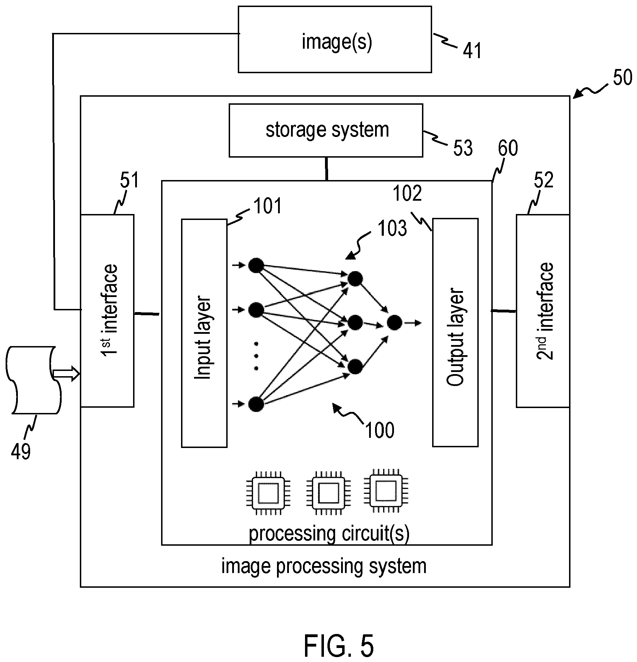

Figure 5 shows an image processing system 50 which comprises at least one ML model 101. The ML model 100 may comprise an input layer 101, an output layer 102, and hidden layers 103. The specific configuration of the ML model 100 may respectively depend on the function which it is intended to perform. The input layer 101 and output layer 102 similarly are dependent on the function which the ML model 100 has in the computer vision system.

The computer vision system may use a first ML model for determining at least one image acquisition time of an image which is to be processed to perform the object classification. In this case, the first ML model may have a first input layer 101 that receives pixels of images of a stream of images. The first ML model may have a first output layer 102 that outputs a value indicating whether or not further analysis is to be performed on any of the images. Alternatively or additionally, the first input layer may receive winding apparatus positions, such as a rotatory and/or translatory position of a winding support on which the transformer winding is being formed.

Identifying the ROI may comprise applying at least one ROI classifier to the at least one image. Several ROI classifiers may be applied to the at least one image. Each of the one or more ROI classifiers may indicate, for each pixel, whether the respective pixel is classified as being within the ROI or outside the ROI.

The one or several ROI classifiers may comprise at least one second ML model. The at least one second ML model may have a second input layer 101 that receives pixels of the at least one image and/or that receives the winding apparatus position(s). The at least one second ML model may have a second output layer 102 that outputs, for every pixel, a value indicating whether or not the respective pixel is in the ROI. Alternatively or additionally, the second input layer may receive winding apparatus positions, such as a rotatory and/or translatory position of a winding support on which the transformer winding is being formed.

The at least one second ML model 100 may comprise a deep learning ML model, such as a U-Net ML model.

The object classification may be performed using at least one third ML model. The at least one third ML model may have a third input layer 101 that receives pixels located within the ROI. The at least one third ML model may have a third output layer 102 that outputs object classification results indicating to which one of several object classes the respective pixel in the ROI is assigned. The third ML model may comprise a random forest (RF) model, without being limited thereto.

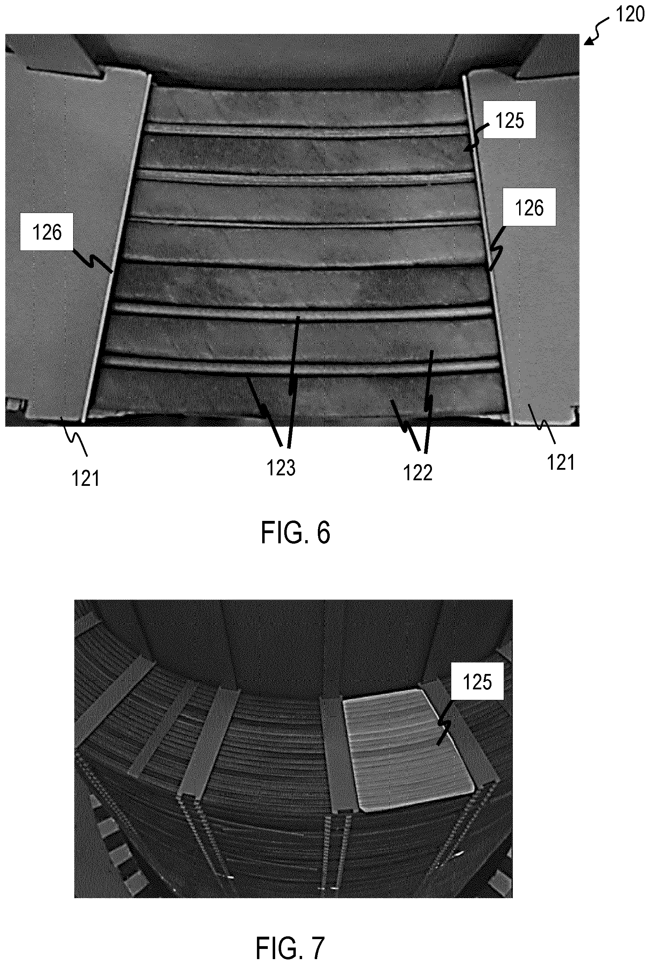

Figure 6 shows an image 120 captured by the image acquisition device 41 while the transformer winding 20 is being formed on the winding apparatus 30.

As mentioned above, optional preprocessing may be performed on the raw image data. The optional preprocessing may be used to take into account perspective effects caused by the arrangement of the optical axis relative to the topmost layer 21. The optional preprocessing may also enhance certain features, such as edges and/or contracts and/or periodicity.

ROI detection identifies ROI 125 in the image 120. The ROI 125 may be delimited by edges 126 of shields 121. The ROI 125 may also be delimited, in a radial direction, by inner and outer circumferential boundaries of the innermost and outermost conductors seen in the image 120.

Object classification is performed to classify objects such as conductors 122 and fillers 123. A sequence of these object types may be determined in a radial direction (i.e., in a radially inward or outward direction). This sequence of object classes is then checked for consistency with the design data. A target sequence of object classes expected when the design data is complied with may be determined. The sequence of object classes determined from the image 120 may be compared to the target sequence.

Figure 7 shows another image with an ROI 125 (determined, in this case, using a trained U-Net ML model as classifier). The ROI detection works reliably. In particular, the topmost layer 21 can be distinguished reliably from the outer cylindrical surface of the already wound transformer winding. Edges of the shields can be reliably determined.

Object classification does not need to be performed for every image obtained or obtainable by the image acquisition device 41. Image acquisition times of images that are analyzed in detail, in particular by performing object classification, may be determined by the computer vision system 40, e.g. by the image processing system 50 thereof.

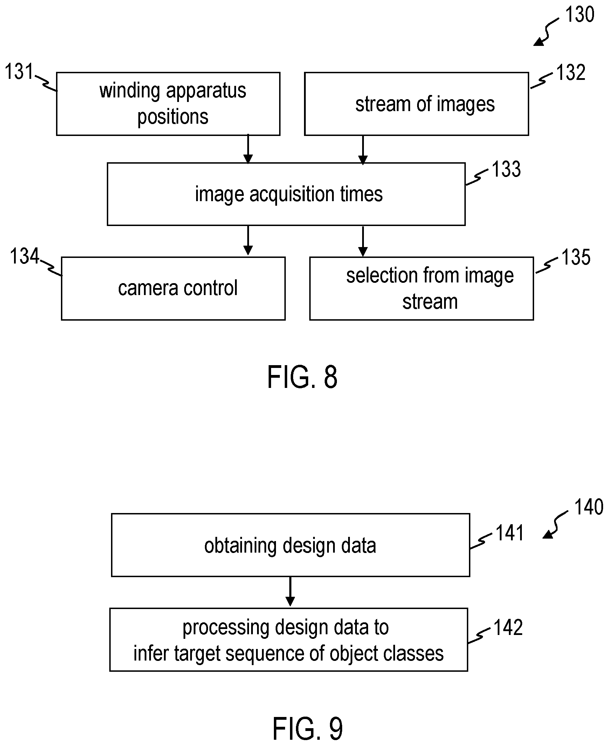

Figure 8 shows a functional block diagram 130 illustrating operation of the computer vision system 40 for determining image acquisition times for which they captured images around further analysis.

The winding apparatus positions 131 and, optionally, r a stream of images 132 serve as input to the determination 133 of the relevant image acquisition times. The design data may optionally be taken into account to determine for which winding apparatus position(s) 131 little occlusion of relevant features can be detected, which is then translated into corresponding image acquisition times during the winding process.

The determined image acquisition times of the images that are to be analyzed in detail can be used in various ways.

A camera control operation 134 may be performed to cause an image acquisition device 41 to perform image acquisition at the desired time. Alternatively or additionally, images may be selected from a stream of images at block 135 (which stream may be acquired continually), in accordance with the determined image acquisition time(s).

As an alternative to determining specific image acquisition times, the image processing may be performed on an ongoing basis. However, it is typically not required (but possible) that each image frame be analyzed.

Figure 9 is a flow chart of a process 140. The process 140 may be performed by the computer vision system 40 or separate computing system coupled to the computer vision system 40. The process 140 translates the design data into a format that can be easily compared to a result of the object classification.

At process block 141, the design data obtained. The design data may be retrieved from a database. The design data may be specific to the particular specification of the transformer in which the transformer winding is to be used. The design data may define a three-dimensional configuration of the transformer winding. The design data may comprise a crossovers diagram but may have alternative formats such as instruction code executed by the winding apparatus or winding apparatus controller.

At process block 142, the design data are processed to infer a target sequence of object classes for the respective winding apparatus position, based on the design data and the status of the winding process (which determines the winding apparatus position).

The target sequence of object classes (also referred to as target sequence of objects herein) may be compared to a result of the object classification performed on the at least one image to detect possible discrepancies.

The computer vision system may comprise one or several ML models but may also use other processing techniques. One challenge encountered when using one or several ML models is the provision of a suitable training set, as the images showing errors during a winding process are, fortunately, rare compared to images that show a perfect operation of the winding process. Methods and systems disclosed herein may synthetically generate additional images showing winding errors, to thereby provide a more balanced training data set. This improves the accuracy during inference.

ML model training may be performed by the computer vision system. ML model training may be repeated during field use of the computer vision system. ML model training may also be performed by a computing system separate from the computer vision system.

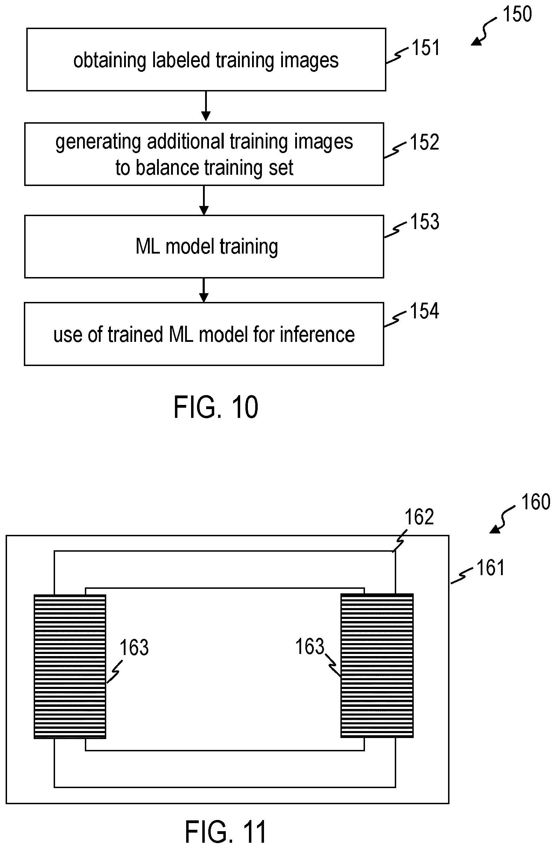

Figure 10 shows a flow chart of a method 150. The method 150 may be performed to train one or several ML models that may be used in the methods or systems for monitoring a winding process.

At process block 151, labeled training images are obtained. The labeled training images may but do not need to be captured on the same winding apparatus on which the ML model is used in the inference phase.

At process block 152, training images labeled as showing a winding error are identified. Additional training images are synthetically generated. Generating the additional synthetic images with labels indicating a winding error may comprise a transformation, such as rotation, translation, distortion, and/or reflection, of an image labeled as showing a winding error.

At process block 153, ML model training is performed using, inter alia, the synthetically generated images.

At process block 154, the trained ML model may be deployed to a computer vision system for inference during field use of the computer vision system.

The ML model may be an ROI detector or an object classifier, without being limited thereto.

According to embodiments, a method of forming a transformer winding on a winding apparatus comprises monitoring the winding process while it is being performed, using the computer vision techniques described in detail herein.

The obtained winding may be assembled to form a transformer core or a transformer, such as a power transmission transformer for, e.g., a high-voltage or medium voltage transmission grid, or a power distribution transformer, a shunt reactor and/or a variable reactor.

Figure 11 schematically shows a transformer 160 that comprises at least one transformer winding 163 formed using the method according to an embodiment. The at least one transformer winding 163 is assembled with a yoke 162 to form a transformer core. The transformer 160 may comprise additional components, such as a transformer tank 161, insulation oil within the transformer tank 161, bushings (not shown), a transformer breather (not shown), etc.

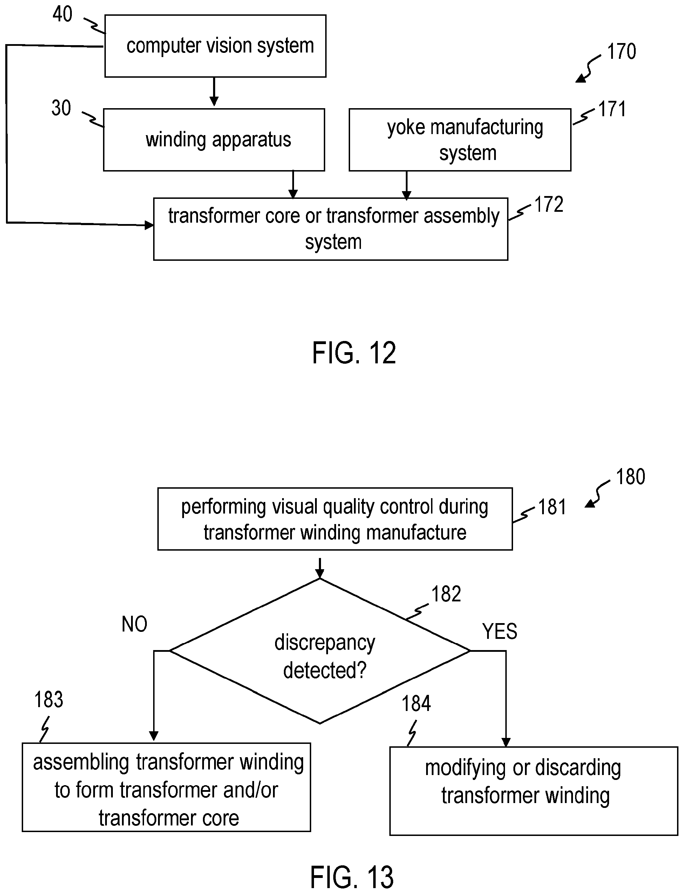

Figure 12 is a block diagram of a manufacturing system 170 configured to manufacture a transformer core of a transformer. The manufacturing system 170 comprises the winding apparatus 30 and a yoke manufacturing system 171. The manufacturing system 170 comprises the computer vision system 40 according to an embodiment.

The transformer winding formed on the winding apparatus 30 under the monitoring activity of the computer vision system 40 is used in association with other transformer components, such as the yoke, to assemble a transformer core or transformer. This assembly may be performed by an assembly system 172.

Figure 13 is a flow chart of a method 180. The method 180 may be performed by the manufacturing system 170.

At process block 181, visual quality control is performed during a winding process, in which a transformer winding is formed on a winding apparatus.

At process block 182, it is determined whether any discrepancy has been detected during the winding process, which discrepancy would indicate that the objects as seen by the computer vision system do not match or do not perfectly match what this expected in accordance with design data.

At process block 183, the transformer winding may be used for assembling a transformer core or transformer if no discrepancy has been detected.

At process block 184, the transformer winding may be discarded if a discrepancy has been detected.

If a discrepancy has been detected but has subsequently been rectified by a suitable corrective action, responsive to detection of the discrepancy, the transformer winding can potentially still be used at process block 183.

While embodiments have been described with reference to the drawings, modifications and alterations may be implemented in other embodiments.

For illustration, while embodiments have been described in which a transformer winding may comprise several discs and shields between the discs, the techniques disclosed herein are not limited to monitoring the winding process of such transformer windings.

For further illustration, while embodiments have been described in which images captured by one image acquisition device are analyzed, the techniques are also applicable when images are captured by more than one image acquisition device. Use of several image acquisition devices may be beneficial to read use potentially adverse effects of a particular occlusions.

For further illustration, while embodiments have been described in which trained ML models may be used to perform certain processing operations, other processing techniques may be used.

For still further illustration, while embodiments have been described in which ROI detection is performed using a classifier, ROI detection may be performed using other techniques that do not involve a classifier, if the ROI detection is performed at all.

For still further illustration, while embodiments have been described in association with monitoring the winding process of a transformer winding, the techniques may also be used to monitor the manufacture of windings used in reactive or inductive systems, such as shunt or variable reactors.

Various effects and advantages are attained by embodiments of the invention. For illustration, embodiments allow mistakes to be detected by a winding process is still ongoing. This allows corrective and/or a mitigating actions to be taken during the winding process. The risk of transformer failure caused by winding errors is reduced.

Methods, systems, and devices are particularly suitable in association with power transformers of electric power transmission systems, such as high-voltage medium voltage transmission systems, or power distribution systems. The methods, systems, and devices are not limited to these applications. For illustration, the techniques disclosed herein may also be used with railway transformers.

This description and the accompanying drawings that illustrate aspects and embodiments of the present invention should not be taken as limiting-the claims defining the protected invention. In other words, while the invention has been illustrated and described in detail in the drawings and foregoing description, such illustration and description are to be considered illustrative or exemplary and not restrictive. Various mechanical, compositional, structural, electrical, and operational changes may be made without departing from the claims. In some instances, well-known circuits, structures and techniques have not been shown in detail in order not to obscure the invention. Thus, it will be understood that changes and modifications may be made by those of ordinary skill within the scope of the following claims.

The disclosure also covers all further features shown in the Figures individually although they may not have been described in the afore or following description. Also, single alternatives of the embodiments described in the Figures and the description and single alternatives of features thereof can be disclaimed from the subject matter of the invention or from disclosed subject matter. The disclosure comprises subject matter consisting of the features defined in the claims or the exemplary embodiments as well as subject matter comprising said features.

The term "comprising" does not exclude other elements or steps, and the indefinite article "a" or "an" does not exclude a plurality. A single unit or step may fulfil the functions of several features recited in the claims. The mere fact that certain measures are recited in mutually different dependent claims does not indicate that a combination of these measures cannot be used to advantage. Components described as coupled or connected may be electrically or mechanically directly coupled, or they may be indirectly coupled via one or more intermediate components. Any reference signs in the claims should not be construed as limiting the scope.

A machine-readable instruction code may be stored/distributed on a suitable medium, such as an optical storage medium or a solid-state medium supplied together with or as part of other hardware, but may also be distributed in other forms, such as via a wide area network or other wired or wireless telecommunication systems. Furthermore, a machine-readable instruction code can also be a data structure product or a signal for embodying a specific method such as the method according to embodiments.

## Claims

1. A method of monitoring a winding process of forming a transformer winding (20) on a winding apparatus (30), the method comprising:
processing, by a computer vision system (40), at least one image (42) showing at least part of the transformer winding (20) captured during the winding process, wherein processing the at least one image (42) comprises performing an object classification;
detecting, by the computer vision system (40), a discrepancy between a result of the object classification and design data (49) for the transformer winding (20);
effecting, by the computer vision system (40), at least one action responsive to the detected discrepancy; and
determining at least one image acquisition time of the at least one image (42) during the winding process based on both a translatory position and a rotary position of the winding apparatus (30) in combination with the design data (49).

2. The method of claim 1,
wherein the at least one action comprises causing, by the computer vision system (40), a human machine interface, HMI (37), to output information that depends on the detected discrepancy.

3. The method of claim 2,
wherein the information comprises one, several, or all of:
an alarm and/or warning;
information indicating a location of the detected discrepancy;
information indicating a time at which the detected discrepancy occurred;
information on a root cause of the detected discrepancy;
instructions for correcting the detected discrepancy.

4. The method of any one of the preceding claims,
wherein the at least one action comprises one or both of:
a mitigating action;
a corrective action.

5. The method of any one of the preceding claims,
wherein the action comprises stopping a rotation and/or translatory displacement of the winding apparatus (30).

6. The method of any one of the preceding claims, further comprising:
performing an image acquisition device control and/or an image selection based on the determined at least one image acquisition time.

7. The method of any one of the preceding claims,
wherein processing the at least one image (42) comprises identifying a region of interest, ROI (125), in which the object classification is to be performed, optionally boundaries of the ROI (125) comprise edges (126) of shields of the transformer winding (20).

8. The method of any one of the preceding claims,
wherein processing the at least one image (42) comprises:
using one or several position measurements of the winding apparatus (30); and/or
executing at least one machine learning, ML, model (100) having an input layer (101) that receives at least part of the at least one image (42) and an output layer (102), wherein the output layer provides a region of interest, ROI (125), in which the object classification is to be performed and/or object classifiers.

9. The method of any one of the preceding claims,
wherein detecting the discrepancy comprises determining, based on the design data (49), a target sequence of objects in a radial direction of the transformer winding (20) and comparing the target sequence and the result of the object classification.

10. The method of any one of the preceding claims,
wherein the object classification classifies
at least conductors, fillers, and shields in the at least one image (42), and/or crossovers, and/or
other components of the transformer winding (20), and/or
other structural features of the transformer winding (20).

11. A method of manufacturing a transformer winding (20), comprising:
controlling, by at least one control device (35), a winding apparatus (30) on which the transformer winding (20) is formed; and
performing the method of any one of the preceding claims while the transformer winding (20) is being formed.

12. A method of manufacturing a transformer core (162, 163) or transformer (160), comprising:
manufacturing at least one transformer winding (20) by the method of claim 11; and
assembling the transformer core (162, 163) or transformer (160) comprising the at least one transformer winding (20).

13. A system configured to monitor a winding process of forming a transformer winding (20) on a winding apparatus (30), the system comprising:
a computer vision system (40) configured to:
process at least one image (42) showing at least part of a transformer winding (20) captured during the winding process to perform an object classification;
detect a discrepancy between results of the object classification and design data (49) for the transformer winding (20);
perform an action responsive to the detected discrepancy; and
determine at least one image acquisition time of the at least one image (42) during the winding process based on both a translatory position and a rotary position of the winding apparatus (30) in combination with the design data (49).

14. The system of claim 13, further comprising:
a human machine interface, HMI (37), wherein the computer vision system (40) is configured to control the HMI responsive to the detected discrepancy.

15. A manufacturing system for manufacturing a transformer winding (20) the system comprising:
a winding apparatus (30); and
the system of claim 13 or claim 14.

## Patentansprüche

1. Verfahren zum Überwachen eines Wickelprozesses zum Bilden einer Transformatorwicklung (20) auf einer Wickelvorrichtung (30), wobei das Verfahren aufweist:
Verarbeiten mindestens eines während des Wickelprozesses aufgenommenen Bildes (42), das wenigstens einen Teil der Transformatorwicklung (20) zeigt, durch ein Computer-Vision-System (40), wobei das Verarbeiten des mindestens einen Bildes (42) ein Durchführen einer Objektklassifizierung aufweist;
Erkennen einer Abweichung zwischen einem Ergebnis der Objektklassifizierung und Konstruktionsdaten (49) für die Transformatorwicklung (20) durch das Computer Vision System (40);
Veranlassen mindestens einer Aktion durch das Computer-Vision-System (40) als Reaktion auf die erkannte Abweichung; und
Bestimmen mindestens einer Bilderfassungszeit des mindestens einen Bildes (42) während des Wickelprozesses basierend auf sowohl einer translatorischen Position als auch einer Drehposition der Wickelvorrichtung (30) in Kombination mit den Konstruktionsdaten (49).

2. Verfahren nach Anspruch 1,
wobei die mindestens eine Aktion aufweist, dass durch das Computer-Vision-System (40) eine Mensch-Maschine-Schnittstelle, HMI (37), veranlasst wird, Informationen auszugeben, die von der erkannten Abweichung abhängen.

3. Verfahren nach Anspruch 2,
wobei die Informationen eines, mehrere oder alle der Folgenden aufweisen:
einen Alarm und/oder eine Warnung;
Informationen, die einen Ort der erkannten Abweichung angeben;
Informationen, die einen Zeitpunkt angeben, zu dem die erkannte Abweichung aufgetreten ist;
Informationen über eine Ursache der erkannten Abweichung;
Anweisungen zum Beheben der erkannten Abweichung.

4. Verfahren nach einem der vorhergehenden Ansprüche,
wobei die mindestens eine Aktion eines oder beide der Folgenden aufweist:
eine abmildernde Aktion;
eine Korrekturaktion.

5. Verfahren nach einem der vorhergehenden Ansprüche,
wobei die Aktion ein Anhalten einer Rotation und/oder einer translatorischen Bewegung der Wickelvorrichtung (30) aufweist.

6. Verfahren nach einem der vorhergehenden Ansprüche, das ferner aufweist:
Durchführen einer Bildaufnahmeeinrichtungssteuerung und/oder einer Bildauswahl basierend auf der bestimmten mindestens einen Bildaufnahmezeit.

7. Verfahren nach einem der vorhergehenden Ansprüche,
wobei das Verarbeiten des mindestens einen Bildes (42) ein Identifizieren eines Bereichs von Interesse, ROI (125), aufweist, in dem die Objektklassifizierung durchgeführt werden soll, wobei optional Grenzen des ROls (125) Kanten (126) von Abschirmungen der Transformatorwicklung (20) aufweisen.

8. Verfahren nach einem der vorhergehenden Ansprüche,
wobei das Verarbeiten des mindestens einen Bildes (42) aufweist:
Verwenden einer oder mehrerer Positionsmessungen der Wickelvorrichtung (30); und/oder
Ausführen mindestens eines Modells des maschinellen Lernens, ML, (100), das eine Eingangsschicht (101), die mindestens einen Teil des mindestens einen Bildes (42) empfängt, und eine Ausgangsschicht (102) aufweist, wobei die Ausgangsschicht einen Bereich von Interesse, ROI (125), in dem die Objektklassifizierung durchgeführt werden soll, und/oder Objektklassifikatoren bereitstellt.

9. Verfahren nach einem der vorhergehenden Ansprüche,
wobei das Erkennen der Abweichung basierend auf den Konstruktionsdaten (49) ein Bestimmen einer Soll-Sequenz von Objekten in einer radialen Richtung der Transformatorwicklung (20) und ein Vergleichen der Soll-Sequenz und des Ergebnisses der Objektklassifizierung aufweist.

10. Verfahren nach einem der vorhergehenden Ansprüche,
wobei die Objektklassifizierung Folgendes klassifiziert:
mindestens Leiter, Füllstoffe und Abschirmungen in dem mindestens einen Bild (42), und/oder
Kreuzungen und/oder
andere Komponenten der Transformatorwicklung (20) und/oder
andere strukturelle Merkmale der Transformatorwicklung (20).

11. Verfahren zum Herstellen einer Transformatorwicklung (20), das aufweist:
Steuern einer Wickelvorrichtung (30), auf der die Transformatorwicklung (20) gebildet wird, durch mindestens eine Steuervorrichtung (35); und
Durchführen des Verfahrens nach einem der vorhergehenden Ansprüche, während die Transformatorwicklung (20) gebildet wird.

12. Verfahren zum Herstellen eines Transformatorkerns (162, 163) oder eines Transformators (160), das aufweist:
Herstellen mindestens einer Transformatorwicklung (20) nach dem Verfahren von Anspruch 11; und
Montieren des Transformatorkerns (162, 163) oder des Transformators (160), der die mindestens eine Transformatorwicklung (20) aufweist.

13. System, das zum Überwachen eines Wickelprozesses zum Bilden einer Transformatorwicklung (20) auf einer Wickelvorrichtung (30) eingerichtet ist, wobei das System aufweist:
ein Computer-Vision-System (40), das konfiguriert ist, um:
mindestens ein Bild (42) zu verarbeiten, das mindestens einen Teil einer Transformatorwicklung (20) zeigt, die während des Wickelvorgangs aufgenommen wurde, um eine Objektklassifizierung durchzuführen;
eine Abweichung zwischen den Objektklassifizierungsergebnissen und Konstruktionsdaten (49) für die Transformatorwicklung (20) zu erkennen;
eine Aktion als Reaktion auf die erkannte Abweichung auszuführen; und
mindestens eine Bilderfassungszeit des mindestens einen Bildes (42) während des Wickelprozesses basierend auf sowohl einer translatorischen Position als auch einer Drehposition der Wickelvorrichtung (30) in Kombination mit den Konstruktionsdaten (49) zu bestimmen.

14. System nach Anspruch 13, wobei das System ferner aufweist:
eine Mensch-Maschine-Schnittstelle, HMI (37), wobei das Computer-Vision-System (40) so konfiguriert ist, dass es die HMI als Reaktion auf die erkannte Abweichung steuert.

15. Herstellungssystem zum Herstellen einer Transformatorwicklung (20), wobei das System aufweist:
eine Wickelvorrichtung (30); und
das System nach Anspruch 13 oder Anspruch 14.

## Revendications

1. Procédé de surveillance d'un processus d'enroulement de formation d'un enroulement (20) de transformateur sur un appareil (30) d'enroulement, le procédé comprenant :
le traitement, par un système de vision par ordinateur (40), d'au moins une image (42) montrant au moins une partie de l'enroulement (20) de transformateur capturée pendant le processus d'enroulement, le traitement de l'au moins une image (42) comprenant la réalisation d'une classification d'objets ;
la détection, par le système de vision par ordinateur (40), d'une différence entre un résultat de la classification d'objets et des données de conception (49) pour l'enroulement (20) de transformateur ;
la réalisation, par le système de vision par ordinateur (40), d'au moins une action en réponse à la différence détectée ; et
la détermination d'au moins un instant d'acquisition d'image de l'au moins une image (42) pendant le processus d'enroulement sur la base à la fois d'une position de translation et d'une position de rotation de l'appareil (30) d'enroulement en combinaison avec les données de conception (49).

2. Procédé selon la revendication 1,
l'au moins une action comprenant le fait qu'une interface homme-machine, HMI (37), est amenée, par le système de vision par ordinateur (40), à délivrer des informations qui dépendent de la différence détectée.

3. Procédé selon la revendication 2,
les informations comprenant :
une alarme et/ou une alerte ; et/ou
des informations indiquant un emplacement de la différence détectée ; et/ou
des informations indiquant un instant auquel la différence détectée s'est produite ; et/ou
des informations concernant une origine de la différence détectée ; et/ou
des instructions de correction de la différence détectée.

4. Procédé selon l'une quelconque des revendications précédentes,
l'au moins une action comprenant :
une action d'atténuation ; et/ou
une action corrective.

5. Procédé selon l'une quelconque des revendications précédentes,
l'action comprenant l'arrêt d'un déplacement en rotation et/ou en translation de l'appareil (30) d'enroulement.

6. Procédé selon l'une quelconque des revendications précédentes, comprenant en outre :
la réalisation d'une commande de dispositif d'acquisition d'image et/ou d'une sélection d'image sur la base de l'au moins un instant d'acquisition d'image déterminé.

7. Procédé selon l'une quelconque des revendications précédentes,
le traitement de l'au moins une image (42) comprenant l'identification d'une région d'intérêt, ROI (125), dans laquelle la classification par objets doit être réalisée, éventuellement, des limites de la ROI (125) comprenant des bords (126) de blindages de l'enroulement (20) de transformateur.

8. Procédé selon l'une quelconque des revendications précédentes,
le traitement de l'au moins une image (42) comprenant :
l'utilisation d'une ou plusieurs mesures de position de l'appareil (30) d'enroulement ; et/ou
l'exécution d'au moins un modèle d'apprentissage machine, ML, (100) ayant une couche d'entrée (101) qui reçoit au moins une partie de l'au moins une image (42) et une couche de sortie (102), la couche de sortie fournissant une région d'intérêt, ROI (125), dans laquelle la classification d'objet doit être réalisée et/ou des classificateurs d'objets.

9. Procédé selon l'une quelconque des revendications précédentes,
la détection de la différence comprenant la détermination, sur la base des données de conception (49), d'une séquence cible d'objets dans une direction radiale de l'enroulement (20) de transformateur et la comparaison de la séquence cible et du résultat de la classification d'objets.

10. Procédé selon l'une quelconque des revendications précédentes,
la classification d'objets classifiant
au moins des conducteurs, des charges et des blindages dans l'au moins une image (42), et/ou
des croisements, et/ou
d'autres composants de l'enroulement (20) de transformateur, et/ou
d'autres caractéristiques structurales de l'enroulement (20) de transformateur.

11. Procédé de fabrication d'un enroulement (20) de transformateur, comprenant :
la commande, par au moins un dispositif de commande (35), d'un appareil (30) d'enroulement sur lequel l'enroulement (20) de transformateur est formé ; et
la réalisation du procédé selon l'une quelconque des revendications précédentes lorsque l'enroulement (20) de transformateur est en train d'être formé.

12. Procédé de fabrication d'un noyau (162, 163) de transformateur ou d'un transformateur (160), comprenant :
la fabrication d'au moins un enroulement (20) de transformateur par le procédé selon la revendication 11 ; et
l'assemblage du noyau (162, 163) de transformateur ou du transformateur (160) comprenant l'au moins un enroulement (20) de transformateur.

13. Système configuré pour surveiller un processus d'enroulement de formation d'un enroulement (20) de transformateur sur un appareil (30) d'enroulement, le système comprenant :
un système de vision par ordinateur (40) configuré pour :
traiter au moins une image (42) montrant au moins une partie d'un enroulement (20) de transformateur capturée pendant le processus d'enroulement afin de réaliser une classification d'objets ;
détecter une différence entre des résultats de la classification d'objets et des données de conception (49) pour l'enroulement (20) de transformateur ;
réaliser une action en réponse à la différence détectée ; et
déterminer au moins un instant d'acquisition d'image de l'au moins une image (42) pendant le processus d'enroulement sur la base à la fois d'une position de translation et d'une position de rotation de l'appareil (30) d'enroulement en combinaison avec les données de conception (49).

14. Système selon la revendication 13, comprenant en outre :
une interface homme-machine, HMI (37), le système de vision par ordinateur (40) étant configuré pour commander l'HMI en réponse à la différence détectée.

15. Système de fabrication pour fabriquer un enroulement (20) de transformateur, le système comprenant :
un appareil (30) d'enroulement ; et
le système selon la revendication 13 ou la revendication 14.
